(19) Europäisches Patentamt

European Patent Office

Office européen des brevets

(11) Publication number : **0 372 749 B1**

## (12) EUROPEAN PATENT SPECIFICATION

(45) Date of publication of patent specification :
**21.09.94 Bulletin 94/38**

(51) Int. Cl.[5] : **H03K 19/173**

(21) Application number : **89312115.2**

(22) Date of filing : **22.11.89**

(54) Semiconductor integrated circuit.

(30) Priority : **09.12.88 GB 8828828**

(43) Date of publication of application :
**13.06.90 Bulletin 90/24**

(45) Publication of the grant of the patent :
**21.09.94 Bulletin 94/38**

(84) Designated Contracting States :
**AT BE CH DE ES FR GB IT LI LU NL SE**

(56) References cited :
**EP-A- 0 270 145**
**GB-A- 2 138 188**
**GB-A- 2 171 546**
**GB-A- 2 180 382**
**GB-A- 2 202 356**

(73) Proprietor : **Pilkington Micro-Electronics
Limited
Prescot Road
St. Helens
Merseyside WA10 3TT (GB)**

(72) Inventor : **Cliff, Richard Guy Maud Cottage
68 Underwood Road
Plimpton
Plymouth Devon PL7 3FZ (GB)**
Inventor : **Austin, Kenneth
226B Chester Road
Hartford
Northwich Cheshire (GB)**

(74) Representative : **Driver, Virginia Rozanne et al
Page White & Farrer
54 Doughty Street
London WC1N 2LS (GB)**

## Description

The present invention relates to electronic integrated circuits of the type comprising configurable logic circuit arrays.

GB-A-2202356 discloses a configurable combinational logic circuit for a configurable logic array which comprises a plurality of logic gates. Each circuit can be configured to perform a particular logic function under the control of binary input signals. Each circuit can be connected to any other circuit through a universally programmable connection network. Each circuit contains sufficient logic gates to enable it to perform any desired logic function.

This invention finds particular utility in a configurable logic circuit array of the type as disclosed in our Specification No. GB-B-2180382 in which the logic circuit array comprises a matrix of discrete sites or cells at each of which is a logic circuit which is adapted to perform a simple logic function. Typically the simple logic function is implemented by means of a two-input NAND gate.

An array of this type is capable of being programmed in such a manner as to configure the various NAND gates, as required, to perform various and different logic functions. One such function is known as a latching function and in the logic array as disclosed in Specification No. GB-B-2180382, a latching function may be implemented using four NAND gates.

This has the disadvantage that the greater number of latching functions that may be required from any logic array the fewer NAND gates remain for other required functions. This has the effect of reducing the overall effectiveness of the array.

An object of this invention is to overcome this disadvantage by providing an additional logic circuit for inclusion in each of the logic circuits at each discrete site to enable each site to have a greater programmable facility and thereby increase the overall utilisation of the array.

Reference is also made to EP-A-0270145 which discloses an emitter coupled logic circuit which includes a by-pass circuit for providing a conductive path for current when a programmable fuse is blown. In a first mode, a clock signal is provided each time an input value is to be written to a latch and in a second mode (when the fuse is blown) input data is transmitted independently of the state of a clock signal so that the circuit functions as a combinatorial circuit.

According to the present invention there is provided a semiconductor integrated circuit including a configurable logic array formed on an area of said integrated circuit, said logic array comprising: a plurality of discrete sites, each site having at least one input and at least one output; a plurality of first logic circuits individually defined at each of said sites, each first logic circuit only being capable of implementing a first simple logic function; and a signal translation system between inputs and outputs of the sites, said signal translation system providing a plurality of direct connection paths between said inputs and outputs wherein each connection path is selectable as to its conduction state, and wherein said signal translation system is a restricted signal translation system by virtue of said direct connection paths extending, for each of said sites, from at least one output of that site to inputs of a respective first set of some of other said sites and from at least one input of that site to outputs of a respective second set of some of other said sites, and wherein each first set for that site is different from the first set of any other site, and wherein each second set for that site is different from the second set of any other site; characterised in that the first logic circuit at each site comprises a logic gate and a first inverter coupled to an output of said logic gate; said logic array further comprises an additional logic circuit at each discrete site, said additional logic circuit including: a second inverter in parallel with and in a back-to-back connection with said first inverter with the input of the first inverter connected to the output of the second inverter thereby to serve as a latching mechanism, and first switching means connected between the output of the logic gate and the input of the first inverter; the first switching means having an input for receiving an input signal for controlling the state of the first switching means; second switching means are connected between the output of the logic gate and the input of the first inverter; and selection control means are provided at each discrete site arranged to supply a control signal to the second switching means so that with the control signal in a first state the second switching means is conductive and enables the first logic circuit to function by itself to implement said first simple logic function and, with the control signal in a second state, the second switching means is non-conductive, causing the first logic circuit to function in combination with the first switching means and the second inverter to implement a latching function.

The logic gate is conveniently a NAND gate.

Preferably, the first switching means is a transmission gate comprising first and second transistors, the transmission gate being controllable to closed and open operative states by signals input to the transmission gate. The second switching means can comprise a single transistor whose conduction state is controlled by the said control signal.

When this is the case, the control signal when present causes the single transistor to be in a conduction state as a consequence of which the transmission gate becomes short circuited and inoperative and thereby the cell operates exclusively as a NAND gate function.

When the control signal is not present, the single transistor would be in a non conduction state enabling the transmission gate to be controlled to the open and closed operative states and the cell operates exclusively as a LATCH circuit function.

It may be arranged that the signal transient time for an input signal to pass to the transmission gate is shorter than the transient time for the same signal to pass through the logic gate to thereby effect rapid switching of the transmission gate between the closed to the open state.

A further aspect of this invention envisages the cascading of a plurality of individual cells which are configured for the LATCH circuit function to form a shift register.

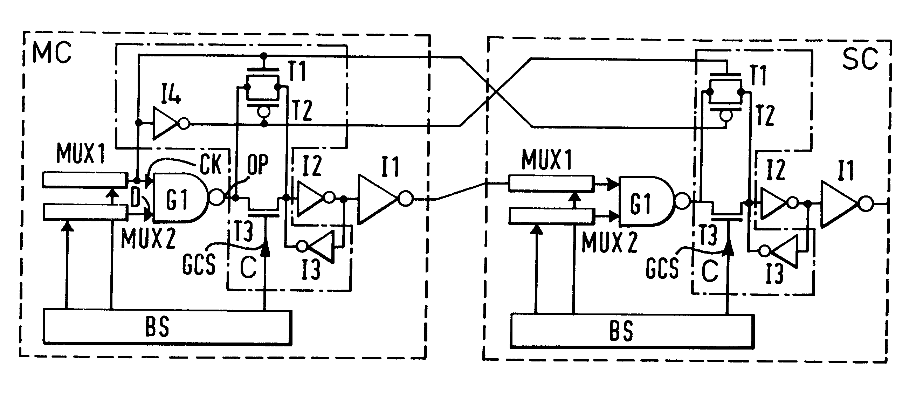

The invention will be more readily understood from the following description of an exemplary embodiment which should be read in conjunction with the accompanying drawing.

The drawing illustrates a schematic diagram of two interconnected logic circuits or cells each of which incorporates the additional logic circuit in accordance with this invention.

Referring to the drawing, for convenience like components in each cell have been identically designated. The two cells shown are master MC and slave SC latch cells.

Each cell comprises a basic two-input NAND gate G1 together with an output buffer I1 in the form of an inverter and a further inverter I2. Referring to the master cell MC, one of the inputs CK of the gate G1 carries clock signals from a multiplexer means MUX1 to the cell while the other input D carries data signals from a further multiplexer means MUX2 to the cell. As disclosed in GB-B-2180382, the multiplexers (MUX1, MUX2) receive signals from neighbouring cells and/or from directly connected bus lines and select an appropriate input to the cell from these signals.

In the Figure, the site MC has two inputs (to MUX1 and MUX2 respectively) and an output from the inverter 11. The site SC has two inputs (to MUX1 and MUX2 respectively) and one output from inverter I1. The sites are used in an array where the sites are interconnected by a signal translation system between inputs and outputs as described more fully in GB 2180382. The signal translation system provides a plurality of direct connection paths between said inputs and outputs wherein each connection path is electrically selectable as to its conduction state, and wherein said signal translation system is a restricted signal translation system by virtue of said direct connection paths extending, for each of said sites, from at least one output of that site to inputs of a respective first set of some of other said sites and from at least one input of that site to outputs of a respective second set of some of other said sites, and wherein each first set for that site is different from the first set of any other site, and wherein each second set for that site is different from the second set of any other site.

An additional logic circuit C is connected between the NAND gate G1 and the output buffer I1. By the utilisation of control signals from a bit store BS, which also provides control signals for the multiplexers MUX1 and MUX2, the additional logic circuit is arranged to change the NAND function of the cell into a LATCH circuit function.

The additional logic circuit comprises an additional inverter I3 which is connected in parallel and in back-to-back relationship with inverter I2 in the existing logic circuit and is so arranged to perform a latching mechanism. A further inverter I4 is included to invert the clock signals from input CK of cell MC to the transistor T2 of cell SC.

Two switching means are provided, the first comprises two transistors T1 and T2 of opposite polarity types connected in parallel to form a transmission gate, and the second a single transistor T3 serving as a simple switch.

In operation, selection of the cell (comprising the logic circuit together with the additional logic circuit) to operate either as a NAND gate function or as a LATCH function, is controlled by a gate control signal GCS which emanates from the bit store BS. When the signal GCS is present the transistor T3 is caused to conduct and the switch short circuits transistors T1 and T2 forming the transmission gate making it inoperative.

In these circumstances the cell operates as a NAND gate function exclusively.

On the other hand when the signal GCS is not present, transistor T3 is not conducting and transistors T1 and T2 are now controlled by the clock signals from the input CK of the NAND gate G1, being applied directly to transistor T1 on the one hand and through an inverter I4 to transistor T2 on the other hand, together with the prevailing output OP of the gate G1 itself to the transmission gate. The signals now passed by the transmission gate (T1 + T2) from the output OP are effectively latched by the latching mechanism comprising inverters I2 and I3. In these circumstances the cell operates as a LATCH circuit function exclusively.

The operation of the latching function and control of the transmission gate are summarised in the following table:

## TABLE 1

| CK | D | OP | TRANSMISSION GATE (T1 + T2) |
|---|---|---|---|
| 1 | 1 | 0 | CLOSED |
| 0 | 0 | 1 | OPEN |
| 1 | 0 | 1 | CLOSED |
| 0 | 1 | 1 | OPEN |

When the input signal CK is at a binary one condition and the transmission gate is closed, the LATCH (I2 and I3) follows the data signal on input D. However, in order to prevent the signal stored in the latch being lost when the transmission gate is about to be opened the signals to the transmission gate must be fast enough to effect a change of state of the switch before the signal at the input of gate G1 is effective at the LATCH (I2 + I3). Thus, a rapid switching of the LATCH (I2 + I3) is achieved as a consequence of the shorter signal transient times for signals to pass to the transmission gate than through the NAND gate G1 itself. In the utilisation of this invention including cells operating in a latch mode as described herein and further interconnected in the manner of a shift register (two such stages being shown as master cell MC and slave cell SC), it is convenient to use the inverted output by way of the inverter I4 from a preceding cell to serve as an inverted clock input to the succeeding cell.

In such an arrangement, it will be apparent to those skilled in the art that using a number of latches cascaded together will form a suitable shift register which not only give an increase in operating speed but will also contribute to a more effective use of the array itself.

**Claims**

1.   A semiconductor integrated circuit including a configurable logic array formed on an area of said integrated circuit, said logic array comprising:

a plurality of discrete sites (MC,SC), each site having at least one input and at least one output;

a plurality of first logic circuits (G1,I2) individually defined at each of said sites, each first logic circuit (G1,I2) only being capable of implementing a first simple logic function;

and a signal translation system between inputs and outputs of the sites, said signal translation system providing a plurality of direct connection paths between said inputs and outputs wherein each connection path is electrically selectable as to its conduction state, and wherein said signal translation system is a restricted signal translation system by virtue of said direct connection paths extending, for each of said sites (MC,SC), from at least one output of that site to inputs of a respective first set of some of other said sites and from at least one input of that site to outputs of a respective second set of some of other said sites, and wherein each first set for that site is different from the first set of any other site, and wherein each second set for that site is different from the second set of any other site;

characterised in that

the first logic circuit (G1,I2) at each site comprises a logic gate (G1) and a first inverter (I2) coupled to an output of said logic gate (G1);

said logic array further comprises an additional logic circuit (C) at each discrete site (MC, SC), said additional logic circuit (C) including: a second inverter (I3) in parallel with and in a back-to-back connection

4

with said first inverter (I2) with the input of the first inverter (I2) connected to the output of the second inverter (I3) thereby to serve as a latching mechanism, and first switching means (T1,T2) connected between the output of the logic gate (G1) and the input of the first inverter (I2), the first switching means having an input for receiving an input signal for controlling the state of the first switching means;

second switching means (T3) are connected between the output of the logic gate (G1) and the input of the first inverter (I2); and

selection control means (BS) are provided at each discrete site arranged to supply a control signal (GCS) to the second switching means so that with the control signal in a first state the second switching means is conductive and enables the first logic circuit (G1,I2) to function by itself to implement said first simple logic function and, with the control signal in a second state, the second switching means is nonconductive, causing the first logic circuit (G1,I2) to function in combination with the first switching means and the second inverter (I3) to implement a latching function.

2. An integrated circuit according to claim 1, wherein the first switching means (T1, T2) is a transmission gate comprising first and second transistors (T1,T2), the transmission gate (T1,T2) being controllable between closed and open operative states by said input signal.

3. An integrated circuit according to claim 2, wherein the logic gate of each logic circuit (G1,I2;C) is arranged to receive said input signal and is such that the transient time for said input signal to pass to the transmission gate (T1,T2) is shorter than the transient time for the same signal to pass through the logic gate (G1) to thereby effect rapid switching of the transmission gate (T1,T2) between the closed and open state.

4. An integrated circuit according to claim 1, 2 or 3, wherein the second switching means (T3) comprises a single transistor (T3) having a control electrode connected to receive the control signal from the selection control means (BS).

5. An integrated circuit according to any preceding claim, wherein the first logic function is a NAND gate function.

6. An integrated circuit according to any preceding claim wherein a plurality of individual sites which are configured for the latching function are cascaded to form a shift register.


**Patentansprüche**

1. Integrierte Halbleiterschaltung mit einem(r) konfigurierbaren logischen Array bzw. Matrix, das/die in einem Bereich auf der integrierten Schaltung ausgebildet ist und umfaßt:

mehrere diskrete Stellen bzw. Abschnitte (MC, SC), wobei jede Stelle wenigstens einen Eingang und wenigstens einen Ausgang aufweist;

mehrere erste logische Schaltungen (G1, I2), die individuell an jeder Stelle definiert bzw. ausgebildet sind, wobei jede erste logische Schaltung (G1, I2) nur eine erste einfache logische Funktion ausführen kann;

und ein Signalübertragungssystem zwischen den Ein- und Ausgängen der Stellen, wobei das Signalübertragungssystem mehrere diskrete Verbindungspfade zwischen den Ein- und Ausgängen umfaßt, wobei jeder Verbindungspfad in seinen Leitungszustand elektrisch schaltbar ist, und wobei das Signalübertragungssystem ein begrenztes Signalübertragungssystem ist aufgrund der direkten Verbindungspfade, die sich von jeder Stelle (MC, SC) von wenigstens einem Ausgang von dieser Stelle zu Eingängen einer entsprechenden ersten Gruppe von einigen anderen Stellen und von wenigstens einem Eingang von dieser Stelle zu Ausgängen einer entsprechenden zweiten Gruppe von einigen anderen Stellen erstreckt, und wobei jede erste Gruppe dieser Stelle verschieden ist von der ersten Gruppe jeder anderen Stelle, und wobei jede zweite Gruppe dieser Stelle verschieden ist von der zweiten Gruppe jeder anderen Stelle;
dadurch gekennzeichnet, daß

die erste logische Schaltung (G1, I2) einen ersten logischen Gatter (G1) und einen ersten Inverter (I2) umfaßt, der an einen Ausgang des logischen Gatters (G1) gekoppelt ist;

das logische Array ferner eine weitere logische Schaltung (C) an jeder diskreten Stelle (MC, SC) umfaßt, wobei die zusätzliche logische Schaltung (C) enthält: einen zweiten Inverter (I3), der parallel und seitenverkehrt zu dem ersten Inverter (I2) geschaltet ist, wobei der Eingang des ersten Inverters (I2) mit dem Ausgang des zweiten Inverters (I3) verbunden ist, um als ein Speichermechanismus zu dienen; und erste Schaltmittel (T1, T2), die zwischen dem Ausgang des logischen Gatters (G1) und dem Eingang des ersten Inverters (I2) angeschlossen sind, wobei die ersten Schaltmittel einen Eingang zum Empfangen eines Eingangssignals zum Steuern des Zustandes der ersten Schaltmittel aufweisen;

zweite Schaltmittel (T3) zwischem dem Ausgang des logischen Gatters (G1) und dem Eingang des ersten Inverters (I2) verbunden sind; und

Auswahlsteuermittel (BS) an jeder diskreten Stelle vorgesehen und angeordnet sind, um ein Steuersignal (GCS) an die zweiten Schaltmittel zu liefern, so daß die zweiten Schaltmittel mit dem Steuersignal in einem ersten Zustand leitend sind, so daß die erste logische Schaltung (I1, I2) von selbst arbeitet, um die erste einfache logische Funktion durchzuführen, und das zweite Schaltmittel mit einem Steuersignal in einem zweiten Zustand nicht leitend ist und bewirkt, daß die erste logische Schaltung (I1, I2) in Verbindung mit den ersten Schaltmitteln arbeitet und daß der zweite Inverter (I3) eine Speicherfunktion durchführt.

2. Integrierte Halbleiterschaltung nach Anspruch 1, dadurch gekennzeichnet, daß das erste Schaltmittel (T1, T2) ein Übertragungsgatter ist mit einem ersten und zweiten Transistor (T1, T2), wobei der Übertragungsgatter (T1, T2) zwischen geschlossenen und offenen Betriebszuständen durch eine Eingangssignal steuerbar bzw. schaltbar ist.

3. Integrierte Halbleiterschaltung nach Anspruch 2, dadurch gekennzeichnet, daß der logische Gatter jeder logischen Schaltung (G1, I2; C) angeordnet ist, um das Eingangssignal zu empfangen und derart ausgebildet ist, daß die Übertragungszeit des Eingangssignals für den Durchlauf durch den Transmissionsgatter (T1, T2) kürzer ist als die Übertragungszeit für dasselbe Signal für den Durchlauf durch den logischen Gatter (G1), um dadurch ein schnelles Schalten des Übertragungsgatters (G1, G2) zwischen dem geschlossenen und offenen Zustand zu bewirken.

4. Integrierte Halbleiterschaltung nach einem der Ansprüche 1, 2 oder 3, dadurch gekennzeichnet, daß das zweite Schaltmittel (T3) einen einzigen Transistor (T3) mit einer angeschlossenen Steuerelektrode umfaßt, um das Steuersignal von dem Auswahlsteuermittel (BS) zu empfangen.

5. Integrierte Halbleiterschaltung nach einem der vorstehenden Ansprüche, dadurch gekennzeichnet, daß die erste logische Funktion eine NAND Gatter-Funktion ist.

6. Integrierte Halbleiterschaltung nach einem der vorstehenden Ansprüche, dadurch gekennzeichnet, daß eine Vielzahl von individuellen Stellen bzw. Abschnitte, die für die Speicherfunktion konfiguriert sind, in Reihe geschaltet sind, um ein Schieberegister zu bilden.

## Revendications

1. Circuit intégré à semi-conducteur incluant une matrice logique configurable formée dans une zone dudit circuit intégré, ladite matrice logique comprenant :

une pluralité de sites discrets (MC, SC), chaque site ayant au moins une entrée et au moins une sortie ;

une pluralité de premiers circuits logiques (G1, I2) définis individuellement au droit de chacun desdits sites, chaque premier circuit logique (G1, I2) étant seulement capable de remplir une première fonction logique simple ;

et un système de traduction de signal entre les entrées et les sorties des sites, ledit système de traduction de signal fournissant une pluralité de trajets de connexion directe entre lesdites entrées et sorties ; chaque trajet de connexion étant susceptible d'être sélectionné de manière électrique en ce qui concerne son état de conduction ; et ledit système de traduction de signal étant un système de traduction de signal limité par le fait que lesdits trajets de connexion directs s'étendent, pour chacun desdits sites (MC, SC), d'au moins une sortie de ce site aux entrées d'un premier ensemble respectif de certains des autres dits sites, et d'au moins une entrée pour ce site aux sorties d'un second ensemble respectif de certains desdits autres sites ; et chaque premier ensemble de ce site étant différent du premier ensemble de n'importe quel autre site, et chaque second ensemble pour ce site étant différent du second ensemble de n'importe quel autre site ;

caractérisé en ce que :

le premier circuit logique (G1, I2) au droit de chaque site comprend une porte logique (G1) et un premier inverseur (I2) connecté à une sortie de ladite porte logique (G1) ;

en ce que ladite matrice logique comprend en outre un circuit logique supplémentaire (C) au droit de chaque site discret (MC, SC), ledit circuit logique supplémentaire (C) incluant : un second inverseur (I3) en parallèle avec ledit premier inverseur (I2) et en montage tête-bêche avec celui-ci, l'entrée du premier inverseur (I2) étant connectée à la sortie dudit second inverseur (I3) pour servir ainsi de mécanisme de verrouillage ; et un premier moyen de commutation (T1, T2) connecté entre la sortie de la porte logique (G1) et la première entrée du premier inverseur (I2), le premier moyen de commutation ayant une entrée pour recevoir un signal d'entrée pour commander l'état du premier moyen de commutation ;

en ce qu'un second moyen de commutation (T3) est connecté entre la sortie de la porte logique (G1) et l'entrée du premier inverseur (I2) ; et,

en ce qu'un moyen de commande de sélection (BS) est prévu au droit de chaque site discret, agencé pour délivrer au second moyen de commutation un signal de commande (GCS) tel que, le signal de commande étant dans un premier état, le second moyen de commutation est conducteur et autorise le premier circuit logique (G1, I2) à fonctionner par lui-même pour remplir ladite première fonction logique simple, et le signal de commande étant dans un second étant, le second moyen de commutation est non conducteur, en faisant que le premier circuit logique (G1, I2) fonctionne en combinaison avec le premier moyen de commutation et le second inverseur (I3) pour remplir une fonction de verrouillage.

2. Circuit intégré selon la revendication 1, dans lequel le premier moyen de commutation (T1, T2) est une porte de transmission comprenant des premier et second transistors (T1, T2), la porte de transmission (T1, T2) pouvant être commandée, par ledit signal d'entrée, entre des états fonctionnels fermé et ouvert.

3. Circuit intégré selon la revendication 2, dans lequel la porte logique de chaque circuit logique (G1, I2 ; C) est agencée pour recevoir ledit signal d'entrée et est telle que le temps de transitoire pour que ledit signal d'entrée traverse la porte de transmission (T1, T2) est plus court que le temps de transitoire pour que le même signal traverse la porte logique (G1), pour effectuer ainsi une commutation rapide de la porte de transmission (T1, T2) entre les états fermé et ouvert.

4. Circuit intégré selon la revendication 1, 2 ou 3, dans lequel le second moyen de commutation (T3) comprend un transistor unique (T3) ayant une électrode de commande connectée pour recevoir le signal de commande provenant du moyen de commande de sélection (BS).

5. Circuit intégré selon l'une quelconque des revendications précédentes, dans lequel la première fonction logique est une fonction de porte NON-ET.

6. Circuit intégré selon l'une quelconque des revendications précédentes, dans lequel une pluralité de sites individuels qui sont conformés pour la fonction de verrouillage sont montés en cascade pour former un registre à décalage.